(19) Europäisches Patentamt
European Patent Office
Office européen des brevets

(11) **EP 3 778 470 A1**

(12) **EUROPEAN PATENT APPLICATION**
published in accordance with Art. 153(4) EPC

(43) Date of publication:
**17.02.2021 Bulletin 2021/07**

(21) Application number: **19777271.8**

(22) Date of filing: **25.03.2019**

(51) Int Cl.:
**B82B 1/00** (2006.01)   **B01D 53/86** (2006.01)
**B01D 53/94** (2006.01)   **B01J 23/72** (2006.01)
**B82Y 30/00** (2011.01)   **C01G 3/02** (2006.01)
**F01N 3/10** (2006.01)

(86) International application number:
**PCT/JP2019/012603**

(87) International publication number:
**WO 2019/189032 (03.10.2019 Gazette 2019/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.03.2018 JP 2018060414**

(71) Applicant: **Furukawa Electric Co., Ltd.**
**Chiyoda-ku**
**Tokyo 100-8322 (JP)**

(72) Inventors:
• **TSUZUKI, Yoshikazu**
**Tokyo 100-8322 (JP)**
• **WAKAE, Mariko**
**Tokyo 100-8322 (JP)**
• **AOKI, Satoshi**
**Tokyo 100-8322 (JP)**
• **MIYOSHI, Goro**
**Tokyo 100-8322 (JP)**

(74) Representative: **Zacco GmbH**
**Bayerstrasse 83**
**80335 München (DE)**

(54) **CRYSTAL ORIENTATION CONTROL COMPLEX**

(57)    It is an object to provide a crystal-orientation controlled complex as a nanocrystal material having improved properties as the nanocrystal material (for example, excellent catalytic activity) as well as excellent handleability as an industrial component.

A crystal-orientation controlled complex comprising a connected assembly having a thin film shape, in which a plurality of crystal pieces are connected with each other, the crystal pieces having a flake shape and having a main surface and an end surface, wherein the main surface has a crystal orientation relative to a specific crystal plane, and the thin film shaped connected assembly has a polarization singularity.

FIG.2

**Description**

Technical Field

The present invention relates to a crystal-orientation controlled complex that is excellent for use as an industrial component.

Background Art

Crystalline materials in nanometer scale (nanocrystal materials) are widely used in various fields, such as catalysts. In the nanocrystal materials, as nanoparticles having a particle diameter in nanometer scale, further miniaturization, control of active surfaces, and the like have been actively considered, in recent years.

For example, Patent Literature 1 proposes a nano single-crystal-plate integrated catalyst in which nano single-crystal-plates having a specific plane of a specific single crystal as one plane are integrated without contacting catalytic active surfaces with each other between adjacent nano single-crystal-plates, what is called a catalyst in nanoflower form. In addition, Patent Literature 1 discloses that use of a nano single-crystal-plate integrated catalyst eliminates the contact of catalytic active surfaces with each other, even in thermal agglomeration, ensures a space (void) in front of the catalytic active surface, can inhibit reduction in catalytic activity by thermal agglomeration, and can maintain catalytic activity in a high state. Patent Literature 1 further discloses that the material cost of the catalyst can be decreased by making a nano single-crystal-plate as the nano single-crystal-plate having a catalytic active surface as (001) plane and made of CuO which is a transition metal oxide.

However, the nano single-crystal-plate integrated catalyst described in Patent Literature 1 and a typical nanocrystal powder have a particle diameter in nano scale (about 20 to 200 nm), and there are problems with handleability in actual use.

The problems with handleability include the following points. (i) Nanocrystal material in powder shape cannot used as it is and is required to be fixed to a carrier having a certain size with an adhesive or the like. In this case, the amount of the nanocrystal material of more than tenfold of the amount of the material to be supported is required to be provided, this causes material loss. (ii) In supporting, the nanocrystal material in powder shape is dispersed and embedded in an adhesive. For example, when using the nanocrystal material as a catalyst, the active surface of the nanocrystal material cannot be effectively located on a supported surface, and catalytic activity of the nanocrystal material cannot sufficiently exert. (iii) The nanocrystal material in powder shape is fine and is required special jigs or facilities in handling, from the viewpoint of preventing scattering of the powder. (iv) The fine nanocrystal material is complicated in washing after production and isolation, is difficult in storing in a fine state, and may be dispersed.

From the viewpoint of recent increased environmental regulation on, for example, exhaust gas emitted from vehicles, factories, and the like, the nano single-crystal-plate integrated catalyst disclosed in Patent Literature 1 has room for further improvement in catalytic activity.

Document List

Patent Literature

Patent Literature 1: Japanese Patent Application Laid-Open No. 2013-240756

Summary of Invention

Technical Problem

The present invention has been made in view of the above problems and an object thereof is to provide a crystal-orientation controlled complex as a nanocrystal material having improved properties as the nanocrystal material (for example, excellent catalytic activity) as well as excellent handleability.

Solution to Problem

[1] An aspect of the present invention is a crystal-orientation controlled complex comprising: a connected assembly having a thin film shape, in which a plurality of crystal pieces are connected with each other, the crystal pieces having a flake shape and having a main surface and an end surface, wherein the main surface has a crystal orientation relative to a specific crystal plane, and the thin film shaped connected assembly has a polarization singularity.

[2] An aspect of the present invention is the crystal-orientation controlled complex according to [1], wherein the crystal piece is a nanocrystal piece.

The presence or absence of the polarization singularity of the nanocrystal-orientation controlled complex can be determined by the observation of a nanocrystal-orientation controlled complex surface with a polarizing microscope. In addition, the nanocrystal-orientation controlled complex of the present invention is not a powder, but has a thin film shape, that is, it extends in a two-dimensional direction to form a thin film and to have a polarization singularity.

[3] An aspect of the present invention is the crystal-orientation controlled complex according to [1] or [2], wherein the crystal plane is an alternately stacked plane of atoms and a close-packed plane of atoms.

[4] An aspect of the present invention is the crystal-orientation controlled complex according to any one of [1] to [3], wherein the main surface forms a surface of the connected assembly.

[5] An aspect of the present invention is the crystal-orientation controlled complex according to any one of [1] to [4], wherein the main surface has higher catalytic activity than the end surface.

[6] An aspect of the present invention is the crystal-orientation controlled complex according to any one of [1] to [5], wherein the crystal piece is an oxide.

[7] An aspect of the present invention is the crystal-orientation controlled complex according to any one of [1] to [6], wherein the crystal piece is a copper oxide.

[8] An aspect of the present invention is the crystal-orientation controlled complex according to any one of [1] to [7], wherein an area in a plan view is 200 mm$^2$ or more and a thickness is 1 to 500 $\mu$m.

[9] An aspect of the present invention is a crystal orientation-controlled composite component wherein the crystal-orientation controlled complex according to any one of [1] to [8] is integrated with a base material.

Effects of Invention

According to an aspect of the present invention, the crystal-orientation controlled complex whose main surface has a crystal orientation to the specific crystal plane, having a thin film shape and further the polarization singularity allows to obtain a crystal-orientation controlled complex as a nanocrystal material having improved properties as the nanocrystal material (for example, excellent catalytic activity) as well as excellent handleability.

According to an aspect of the present invention, since the main surface has higher catalytic activity than the end surface and the main surface forms a surface having a thin film shape, properties as the nanocrystal material (for example, excellent catalytic activity) can be further improved.

Brief Description of Drawings

[FIG. 1] A schematic perspective view of a nanocrystal-orientation controlled complex of the present invention having a thin film shape.

[FIG. 2] A schematic enlarged view of a thin film surface of the nanocrystal-orientation controlled complex of the present invention having a thin film shape.

[FIG. 3] (FIG. 3A) An optical micrograph of the nanocrystal-orientation controlled complex of the present invention, (FIG. 3B) A polarizing micrograph of the nanocrystal-orientation controlled complex of the present invention.

[FIG. 4] A SEM image of the thin film surface of the nanocrystal-orientation controlled complex of the present invention having a thin film shape.

[FIG. 5] A diagram illustrating a crystal structure of a CuO nanocrystal-orientation controlled complex which is an example of the nanocrystal-orientation controlled complex of the present invention.

[FIG. 6] A graph of the results showing NO reduction rate of the nanocrystal-orientation controlled complex in Examples of the present invention.

[FIG. 7] A graph of the results showing N$_2$ generation rate of the nanocrystal-orientation controlled complex in Examples of the present invention.

Description of Embodiments

<Nanocrystal-orientation controlled complex>

A crystal-orientation controlled complex of the present invention has a flake shape nanocrystal-orientation controlled complex, and is a connected assembly having a thin film shape, with a plurality of nanocrystal pieces having a main surface and an end surface connected with each other, and is characterized in that the main surface has a crystal orientation of a specific crystal plane, and characterized by having a thin film shape and further having a polarization singularity.

The nanocrystal-orientation controlled complex of the present invention forms a thin film, in which the plurality of nanocrystal pieces is connected with each other and is extended in a two-dimensional direction, differing from conventional nanocrystal materials in powder shape. Thus, similar handling as members having a thin film shape or sheet shape becomes possible in actual use, and (i) the nanocrystal-orientation controlled complex can selectively cover a desired part of a carrier to be covered, and only a necessary quantity of the nanocrystal-orientation controlled complex may be prepared, this enables to prevent material loss. (ii) The nanocrystal-orientation controlled complex having a thin film shape can be used by attaching to the carrier with an adhesive, and for example, when used as a catalyst, a catalytic active surface of the nanocrystal-orientation controlled complex can effectively located to a desired part of the carrier to be supported (reaction surface) and can obtain excellent catalytic activity. (iii) With the thin film shape, scattering in handling can be prevented and handleability is excellent. (iv) With the thin film shape, washing and isolation after production is easy and storing is also easy because of being free from scattering.

Since the nanocrystal-orientation controlled complex of the present invention is the nanocrystal-orientation controlled complex having a thin film shape and a polarization singularity, excellent properties as the nanocrystal material (for example, excellent catalytic activity) can be exerted.

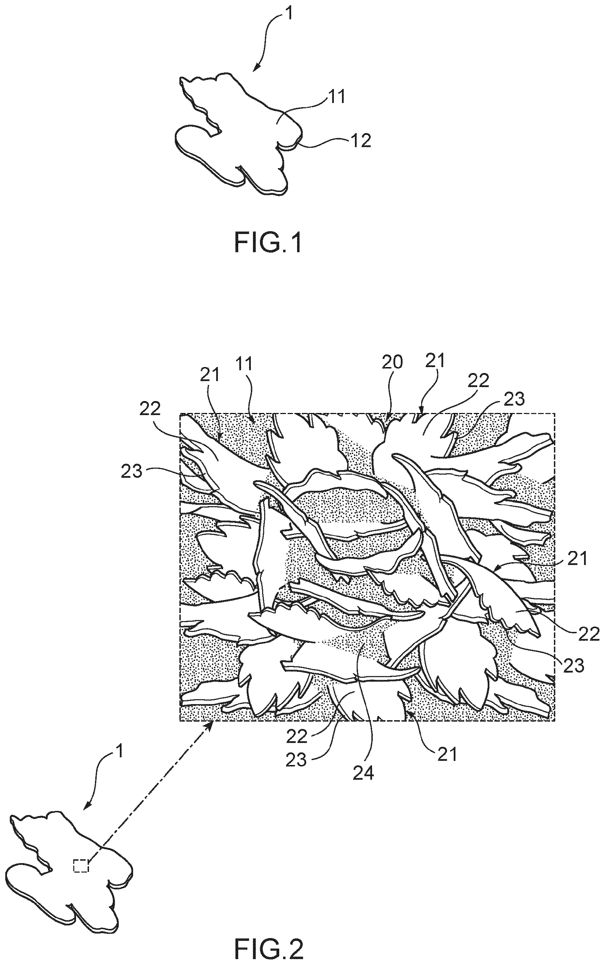

FIG. 1 is a nanocrystal-orientation controlled complex 1 according to an embodiment of the present invention including a surface part 11 and a side surface part 12, wherein the surface part 11 extends in a two-dimensional direction and has a thin film shape. The lower limit value of the area in a plan view of the surface part 11 is preferable to be 200 mm$^2$ or more, more preferable to be 250 mm$^2$ or more, and particularly preferable to be 300 mm$^2$ or more, for example, in terms of properties specific to the nanocrystal material such as excellent catalytic activity and handleability.

The lower limit value of the average height of the side surface part 12, that is, the average thickness of the nanocrystal-orientation controlled complex 1 is preferable to be 1 μm or more, and particularly preferable to be 10 μm or more, for example, in terms of properties specific to the nanocrystal material such as excellent catalytic activity and handleability.

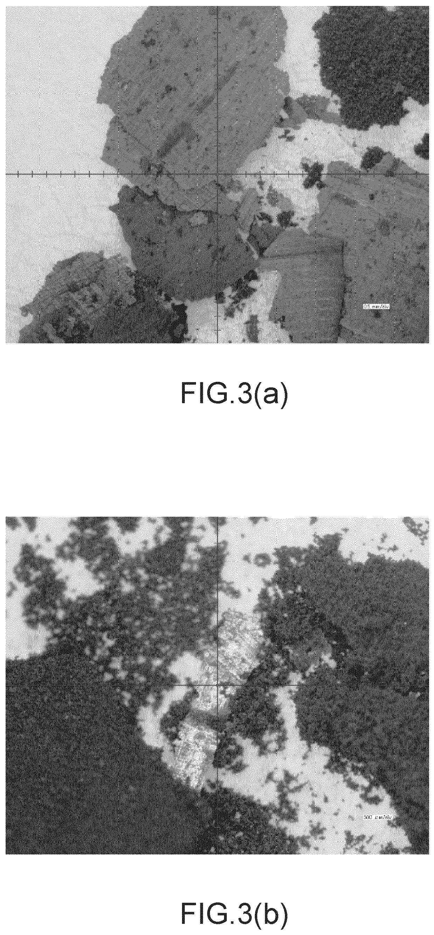

As shown in FIG. 3A and FIG. 3B, the nanocrystal-orientation controlled complex 1 according to an embodiment of the present invention has a thin film shape and a gloss. The gloss of the nanocrystal-orientation controlled complex 1 is not derived from flatness of the surface but derived from polarization singularity. Having a thin film shape and further having a gloss and polarization singularity, the nanocrystal-orientation controlled complex 1 can exert excellent properties as a nanocrystal material, such as excellent catalytic activity, as compared with a nanocrystal material complex having a thin film shape but having no gloss and no polarization singularity. As described below, the controlled crystal orientation of the surface part 11 of the nanocrystal-orientation controlled complex 1 allows to exert excellent properties as a nanocrystal material, such as excellent catalytic activity, and the controlled crystal orientation of the surface part 11 of the nanocrystal-orientation controlled complex 1 makes the nanocrystal material to have a gloss and polarization singularity.

The presence or absence of a gloss of the thin film shape in the nanocrystal-orientation controlled complex 1 can be observed with a light microscope or a microscope, and when the nanocrystal-orientation controlled complex 1 has an area of a given size in a plan view, the nanocrystal-orientation controlled complex 1 is visible with the naked eye. The presence or absence of polarization singularity of the thin film shape in the nanocrystal-orientation controlled complex 1 can be observed with a polarizing microscope. Noted that, the conventional nanocrystal materials in powder shape have neither a gloss nor polarization singularity even when aggregated into a thin film shape, because its constitutional unit is powder shape.

As shown in FIG. 2, the nanocrystal-orientation controlled complex 1 according to an embodiment of the present invention has a flake shape and consists of connected assembly 20 having a thin film shape, in which a plurality of nanocrystal pieces 21 consisting of the main surface 22 and the end surface 23 are connected with each other. The connection state of nanocrystal pieces 21 is not particularly limited, and may be a chemical bonding such as crystal growth, electrical bonding such as electrostatic force, and bonding by integration such as intermolecular force, as long as nanocrystal pieces 21 are connected to form an assembly having a thin film shape as a whole. In particular, the connected assembly 20 is preferable to be connected and integrated by chemical bonding of nanocrystal pieces 21 with each other.

The connected assembly 20 includes a connection base 24 which is formed by connecting the plurality of nanocrystal pieces 21 with each other. The connection base 24 has an appropriately thin film shape. The nanocrystal pieces 21 are connected densely with each other via the connection base 24. Connecting densely the plurality of nanocrystal pieces 21 with each other via the connection base 24 makes a plurality of the main surface 22 connected densely with each other via the connection base 24 at given intervals.

As shown in FIG. 2, since the plurality of the main surfaces 22 are connected densely with each other at given intervals, the main surface 22 of the nanocrystal piece 21 mainly forms the surface part 11 of the nanocrystal-orientation controlled complex 1 having a thin film shape. The area in a plan view of the surface of the connection base 24 appropriately corresponds to the area in a plan view of the surface part 11. The main surface 22 of the nanocrystal piece 21 mainly forms the surface part 11 of the nanocrystal-orientation controlled complex 1, and thus the nanocrystal-orientation controlled complex 1 has properties specific to the nanocrystal material such as excellent catalytic activity. In addition, the connection base 24 has an appropriately thin film shape, and thus the nanocrystal-orientation controlled complex 1 has excellent handleability.

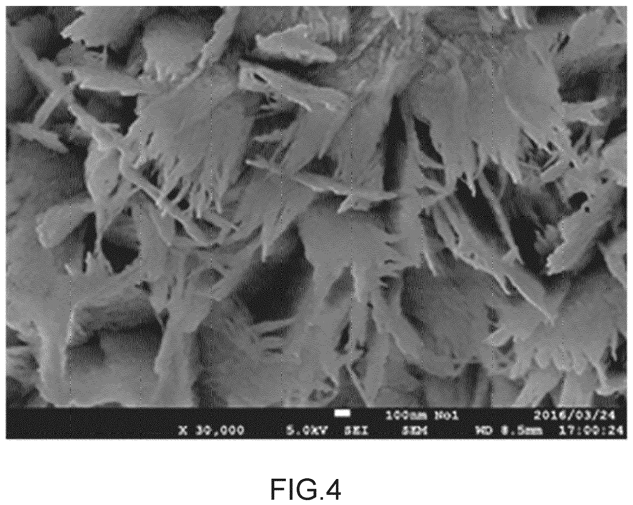

As shown in FIG. 2 and FIG. 4, the connected assembly 20 is formed by connecting the plurality of nanocrystal pieces 21, with the plurality of nanocrystal pieces 21 projected from the surface of the connection base 24 in a random direction. The connected assembly 20 has a structure connected with the plurality of nanocrystal pieces 21, what is called, nanoflower form. The connected assembly 20 having such the plurality of nanocrystal pieces 21 can exert properties specific to the nanocrystal material, though the area in a plan view is, for example, milli scale or more. In the connected assembly 20, the connection state of the nanocrystal piece 21 connected to the connection base 24 is not particularly limited and include above-described bonding state, and in terms of increasing bond strength between the connection base 24 and the nanocrystal piece 21, the nanocrystal piece 21 is preferable to be connected to the connection base 24 via a chemical bonding.

The nanocrystal piece 21 is a part constituting the connected assembly 20 and connected to form the connection base 24 having an appropriately thin film shape. Such the nanocrystal piece 21 has a flake shape and includes the main surface 22 and the end surface 23. As used herein, the main surface 22 of the nanocrystal piece 21 has a large surface area among outer surfaces constituting the nanocrystal piece 21 having a flake shape, and means the both surfaces that partition the upper and lower end of the end surface 23 having a narrow surface area.

The minimum dimension and the maximum dimension of the main surface 22 of the nanocrystal piece 21 are determined by measuring the nanocrystal piece 21 projected from the connection base 24 as an individual nanocrystal piece 21, in order not to impair the shape of the nanocrystal piece 21. Specific example of the measurement method includes depicting a rectangle Q having a minimum area circumscribing to the main surface 22 of the nanocrystal piece 21 and measuring a short side L1 and a long side L2 of the rectangle Q as the minimum dimension and the maximum dimension of the nanocrystal piece 21, respectively. The minimum dimension of the main surface 22 of the nanocrystal piece 21 (for example, a dimension in the width direction) is not particularly limited and is preferable, for example, to be 1 nm to 2 $\mu$m, and the maximum dimension (for example, dimension in the projection direction) is not particularly limited and is preferable, for example, to be 10 nm to 10 $\mu$m. The maximum dimension of the end surface 23 of the nanocrystal piece 21 is not particularly limited and is preferable, for example, to be 1/10 or 10 nm or less of the minimum dimension of the main surface 22. The proportion of the surface area of the main surface 22 to the surface area of the end surface 23 in the nanocrystal piece 21 is not particularly limited and for example, when properties specific to the nanocrystal material is catalytic activity, the proportion is preferable to be 10 times or more in terms of achieving more excellent catalytic activity. The thickness of the nanocrystal piece 21 is preferable to be 0.5 to 100 nm and particularly preferable to be 1 to 20 nm. Considering the relation with the thickness of the nanocrystal piece 21, the minimum dimension of the main surface 22 of the nanocrystal piece 21 is preferable to be 10 times or more and particularly preferable to be 20 times or more of the thickness of the nanocrystal piece 21.

The connected assembly 20 has a relatively high specific surface area, since the connected assembly 20 is formed by connecting the plurality of nanocrystal pieces 21, with the plurality of nanocrystal pieces 21 projected from the surface of the connection base 24 in a random direction. The specific surface area of the connected assembly 20 is preferable to be 5 m$^2$/g or more and particularly preferable to be 10 m$^2$/g or more. The upper limit of the specific surface area of the connected assembly 20 is not particularly limited, but the upper limit as the manufacturing and physical limits is, for example, 100 m$^2$/g. The nanocrystal-orientation controlled complex 1 including the connected assembly 20 having above-described high specific surface area can exert excellent catalytic activity as properties specific to the nanocrystal material such as high catalytic activity at low temperatures, for example, when used as a catalyst.

The nanocrystal piece 21 constituting the nanocrystal-orientation controlled complex 1 of the present invention is preferable to be constituted by at least one of metals and metal oxides. Examples of the metal include a noble metal, a transition metal, and an alloy containing these metals. Examples of the noble metal and alloy thereof include a metal consisting of one component selected from the group of palladium (Pd), rhodium (Rh), ruthenium (Ru), platinum (Pt), silver (Ag) and gold (Au) or an alloy containing one or more components selected from these group. Examples of the transition metal and alloy thereof include a metal consisting of one component selected from the group of copper (Cu), nickel (Ni), cobalt (Co) and zinc (Zn) or an alloy containing one or more components selected from these group. Examples of the metal oxide include the above-described noble metal, the transition metal, or an oxide and a complex oxide of the alloy thereof.

The nanocrystal piece 21 is particularly preferable to be consisted of the metal oxide containing one or two or more metals selected from the group of the transition metal. Such the metal oxide exists in abundance on the earth as metal resources and inexpensive as compared with the noble metal, and thus costs can be restrained. Among the transition metal, the metal oxide is preferable to contain one or two or more metals selected from the group of Cu, Ni, Co and Zn and such the metal oxide is particularly preferable to contain at least copper. Examples of the above-described metal oxide include, nickel oxide, copper oxide, Ni-Cu oxide, Cu-Pd oxide, and among them, copper oxide and Ni-Cu complex oxide are preferable.

The nanocrystal-orientation controlled complex 1 of the present invention has not only the thin film shape having above-described given area in a plan view, but also is an integrated body in which the plurality of nanocrystal pieces 21 is connected with each other, and thus can exert properties specific to the nanocrystal material. Such the nanocrystal-orientation controlled complex 1 can be handled as a macro thin film having a milli-scale or more area in a plan view, and excellent unconventional handleability and workability can be realized as the nanocrystal material. On the other hand, a surface texture, that cannot be realized in the conventional metallic foil such as an electrolytic copper foil, can be realized and properties specific to the nanocrystal material such as a nanocrystal powder can be exerted, while having the thin film shape.

The nanocrystal-orientation controlled complex 1 of the present invention can be used for various applications and may be used, for example, as a catalyst, an electrode material, and an artificial photosynthetic material. In particular, the nanocrystal-orientation controlled complex 1 of the present invention is not required to disperse and embed in an adhesive for supporting on a base material like a nanocrystal powder, when used as a catalyst. Therefore, the catalytic active surface of the nanocrystal-orientation controlled complex 1 can effectively be located on a reaction surface, so that, catalytic efficiency is improved.

When the nanocrystal-orientation controlled complex 1 of the present invention is used as a catalyst, the main surface 22 is controlled to have a specific crystal orientation (crystal plane), so that the main surface 22 forming the surface of the nanocrystal-orientation controlled complex 1 having a thin film shape mainly becomes an active surface. Further, when the nanocrystal-orientation controlled complex 1 is used as a catalyst, the nanocrystal piece 21 is preferable to be constituted from the metal oxide.

For constituting the main surface 22 of the nanocrystal piece 21 to be a catalytic active surface having a reducing property, metal atoms exerting catalytic activity are arranged to locate on the main surface 22 and constituting the main surface 22 with a metal atom surface, in the metal oxide constituting the nanocrystal piece 21. Examples of forming the main surface 22 from the metal atom surface include making the proportion of the number of metal atoms to the metal atoms and oxygen atoms constituting the metal oxide present on the main surface 22 to be 80% or more. When metal atoms are densely arranged as the metal atom surface constituted by metal atoms, catalytic activity is improved, and thus the main surface is preferable to be constituted by the specific crystal plane densely arranged.

On the other hand, for constituting the main surface 22 of the nanocrystal piece 21 to be a catalytic active surface having an oxidizing property, oxygen atoms exerting catalytic activity are arranged to locate on the main surface 22 and constituting the main surface 22 with an oxygen atom surface, in the metal oxide constituting the nanocrystal piece 21. Examples of forming the main surface 22 from the oxygen atom surface include making the proportion of the number of oxygen atoms to the metal atoms and oxygen atoms constituting metal oxide present on the main surface 22 to be 80% or more. When oxygen atoms are densely arranged as the oxygen atom surface constituted by oxygen atoms, catalytic activity is improved, and thus the main surface is preferable to be constituted by the specific crystal plane densely arranged.

By adjusting the proportion of the number of metal atoms or oxygen atoms in the metal atoms and oxygen atoms constituting the metal oxide present on the main surface 22 of the nanocrystal piece 21, in accordance with the role of the catalytic active surface, the main surface 22 of the nanocrystal piece 21 can be increased to have a desired catalytic activity function, which in turn allows to improve a catalytic activity function as the nanocrystal-orientation controlled complex 1.

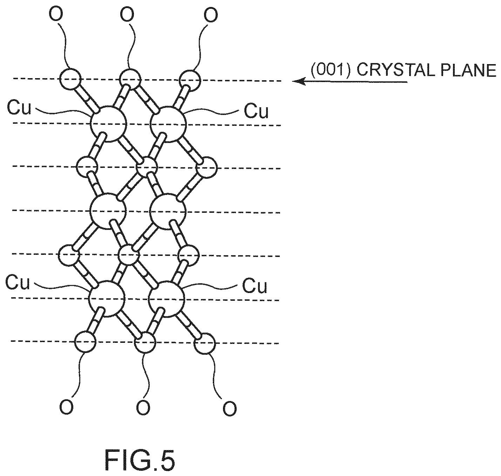

The description that the main surface 22 of the nanocrystal piece 21 is constituted by the specific crystal plane whose crystal orientation is controlled is because the preferential crystal plane to the catalytic activity is varies in accordance with the types of the metal oxide constituting the nanocrystal piece 21, and the crystal orientation (crystal plane) of the main surface 22 is not specifically described. For example, when the metal oxide is copper oxide (CuO), the main crystal plane of a single crystal constituting the main surface is preferable to be (001) plane, as shown in FIG. 5. The reason is that the (001) plane of the ideal copper oxide (CuO) crystal has a structure alternately stacking a plane aligned with copper (Cu) atoms and a plane aligned with oxygen (O) atoms, copper (Cu) atoms and oxygen (O) atoms are not existing on the same plane, and the (001) plane is a close-packed plane of atoms on which a lot of atoms are aligned. The (010) plane of the copper oxide (CuO) is also a plane on which copper (Cu) atoms and oxygen (O) atoms are alternately stacking, but the number of atoms aligned on the plane is fewer than the (001) plane, and the smallest area of a square on a plane made of oxygen (O) atoms is 5.65 $nm^2$ with the (001) plane and is as wide as 23.58 $nm^2$ with the (010) plane, and the atoms on the (010) plane are non-dense alignment than the (001) plane. Varying in magnitudes of surface energy qualitatively corresponds to the density of atoms and close-packed plane of atoms on which a lot of atoms are aligned shows higher value in catalytic activity. The (110) plane, having a high surface energy next to the (001) plane, has some copper (Cu) atoms on a plane on which oxygen (O) atoms are aligned and has no stacked structure, and the area of a square on a plane made of oxygen (O) atoms is 14.7 $nm^2$ with the (110) plane and the alignment of the atoms are not denser than the (001) plane. The density of atoms in a plane conveniently corresponds to an interplanar spacing and a large interplanar spacing makes the number of atoms in a plane dense and a narrow interplanar spacing makes the number of atoms in a plane non-dense, so that atoms are hardly stacked alternately. Thus, a larger interplanar spacing is considered to have higher catalytic activity, as an indication of catalytic activity. Typically, crystals are grown in a shape so as to have lowest surface energy, so that crystals often have a spherical shape and a shape in which a plane having low surface energy was preferentially grown. For example, the (010) plane having lowest surface energy is preferentially generated in the copper oxide (CuO), as described above, whereas, the (001) plane having higher surface energy hardly constitute the crystal plane. However, in the nanocrystal-orientation controlled complex of the invention of the present application, the main crystal plane of the single crystal (the main surface 22 of the nanocrystal piece 21) is the (001) plane, and thus has a higher catalytic activity function.

For example, when copper oxide (CuO) whose main surface 22 of the nanocrystal piece 21 is controlled by a specific crystal orientation is produced, copper oxide (CuO) having a specific crystal orientation can be produced by controlling a metal complex consisting of $Cu^{2+}$ ion and $OH^-$ ion in a mixed solution to a given crystal orientation, connecting and locating with hydrogen bonding, then conducting dehydration reaction. As shown in FIG. 5, a control method for precipitating the copper oxide in order that the main surface 22 corresponds to the (001) plane where copper atoms and oxygen atoms are alternately densely located is applied to the present invention, so that the main surface 22 has higher catalytic activity than the end surface 23. The crystal orientation can be quantified by X-ray diffraction measurement. In X-ray diffraction spectrum of the X-ray diffraction measurement, the crystal plane (002) has a peak at 35.64 degrees, the crystal plane (200) plane has a peak at 39.2 degrees, the crystal plane (-1 11) plane has a peak at 35.76 degrees, and the crystal plane (111) plane has a peak at 38.96 degrees, and the peak intensity in the X-ray diffraction spectrum becomes strong in accordance with degrees of crystal orientation. No peak corresponding to the (001) plane appears in X-ray diffraction spectrum by the extinction rule, and if the peak of the crystal plane (002) appears, this peak corresponds to the orientation of the (001) plane.

<Production method for nanocrystal-orientation controlled complex>

The production method for the nanocrystal-orientation controlled complex according to an embodiment of the present invention includes, for example, preferentially causing two-dimensional growth of the nanocrystal piece to prepare a nanocrystal complex having a thin film shape, in which the plurality of nanocrystal pieces is connected with each other. To prepare the nanocrystal complex having a thin film shape, for example, a boundary surface contacting with the boundary where different phases exist, such as between a gas phase and a liquid phase, between a gas phase, a liquid phase, and a solid phase, is utilized as a nucleation place. Specifically, the nanocrystal complex having a thin film shape, in which the plurality of nanocrystal pieces are connected with each other, is prepared on a boundary surface, such as a boundary surface between a gas and a solution, a boundary surface between a gas, a solution, and a solid that is the wall surface of a reaction apparatus, a boundary surface between different types of solutions, and a boundary surface with a base material (support) located in a solution. The production method of the present invention causes two-dimensional growth by limiting the nucleation place and production with lower temperature than a normal hydrothermal technique is desirable.

Among the nanocrystal complex having a thin film shape prepared as described above, an orientation-controlled complex that has an increased proportion of a nanocrystal having polarization singularity can be produced by specifying and sorting the nanocrystal complex having a gloss in the thin film shape with a light microscope, a microscope or the naked eye, or by specifying and sorting the nanocrystal complex having polarization singularity in the thin film shape with a polarizing microscope.

Hereinabove, the nanocrystal-orientation controlled complex according to the embodiment of the present invention is described, but the present invention is not limited to the above embodiments, encompasses every aspect contained in the concept and claims of the present invention, and can be various modified within a range of the present invention.

[Example]

Thereafter, Example of the present invention will be described, but the present invention is not limited to this Example, unless going beyond the scope thereof.

(Example)

After mixing 2.0 g of copper(ii) chloride hydrate (manufactured by Junsei Chemical Co.,Ltd.) and 1.6 g of urea (manufactured by Junsei Chemical Co.,Ltd.), 180 ml of ethylene glycol (manufactured by Junsei Chemical Co.,Ltd.) and 120 ml of water were added thereto and further mixed. The resulting mixed solution of copper chloride and urea was charged into a pressure glass vessel having an inner capacity of 500 ml and was conducted heat treatment in a sealed atmosphere in the vessel at 150°C for 12 hours. Subsequently, the mixed solution was cooled to room temperature and held for 1 day to generate a nanocrystal complex that is a floating matter having a thin film shape, from the sealed vessel. The produced nanocrystal complex was collected and washed with methanol and pure water, then vacuum-dried at 70°C for 10 hours under vacuum to produce a nanocrystal-orientation controlled complex consisting of a connected assembly having a thin film shape, with nanocrystal pieces of a copper oxide connected. Further, the presence or absence of a gloss of the collected nanocrystal complex was observed with a light microscope, a microscope, or the naked eye, to obtain a catalyst material of a nanocrystal complex having a gloss, that is, a nanocrystal-orientation controlled complex having polarization singularity (nanocrystal-orientation controlled complex having thin film shape, a gloss, and polarization singularity).

(Comparative Example)

The catalyst was prepared in the same manner as in Example except that a nanocrystal complex having no gloss (nanocrystal complex having no polarization singularity) was sorted and harvested by observing the presence or absence of a gloss of the collected nanocrystal complex with a light microscope or the naked eyes, instead of sorting and harvesting the nanocrystal complex having a gloss (nanocrystal complex having polarization singularity) by observing the presence or absence of a gloss of the collected nanocrystal complex with a light microscope, a microscope, or the naked eye, in Example.

[Evaluation]

The catalytic performance was evaluated by using the catalyst according to the above Example and Comparative Example. The evaluation of the catalytic performance was conducted with a testing apparatus consisting of gas supply lines, reaction tubes, and gas sampling parts. This process is specifically as follows.

First, 20 mg of catalyst was charged between glass filters of the reaction tube. Then, the reaction tube charged with the catalyst was set to a constant-temperature bath of the testing apparatus at room temperature. Subsequently, carrier gas (helium) was allowed to flow and heated to 200°C and the water adsorbed to the surface was removed, followed by charging a certain amount of raw material gas to the reaction tube and harvesting and subjecting the reaction tube outlet gas to a gas analysis every certain time, thereby calculating the NO reduction rate and the $N_2$ generation rate as catalytic performance.

As the raw material gas, nitric oxide- and carbon monoxide-containing gas (mixed gas of 1% NO, 1% CO, and balance of helium in a volume ratio) was used.

The NO reduction rate and the $N_2$ generation rate were calculated from respective amount of nitrogen and nitric oxide (ppm) in the gas harvested from the inlet and outlet of the above reaction tube, according to the following formula (1) and (2).

$$\text{NO reduction rate (\%)} = \{\text{NO(inlet)-NO(outlet)}\} \times 100/\text{NO(inlet)} \ldots (1)$$

$$\text{N}_2 \text{ generation rate (\%)} = \text{N}_2\text{(outlet)} \times 100/\text{NO(inlet)} \ldots (2)$$

In the present Example, 50% or more of each of NO reduction rate and $N_2$ generation rate was evaluated as good.

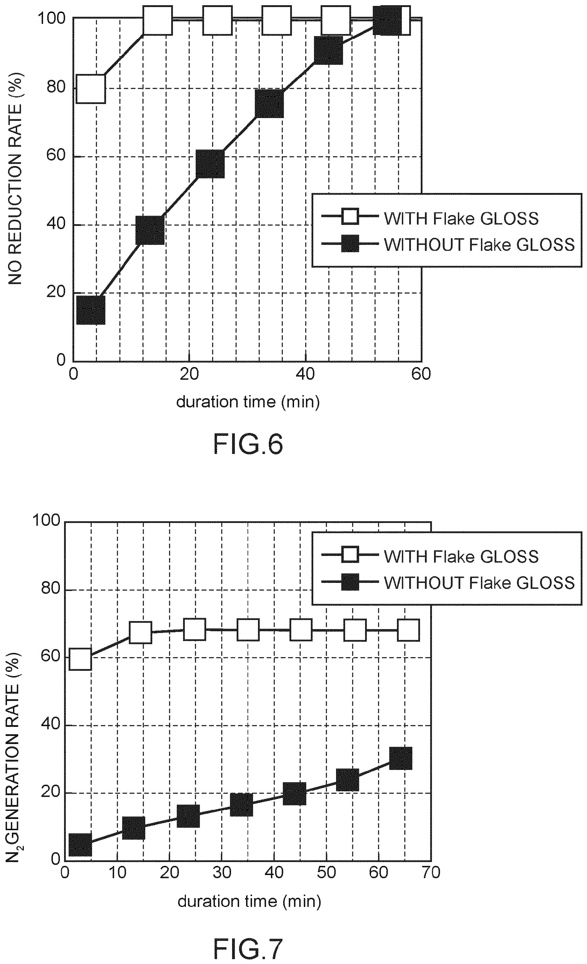

The measurement result of NO reduction rate (%) is shown in FIG. 6, and the measurement result of $N_2$ generation rate (%) is shown in FIG. 7, respectively.

As shown in FIG. 6, in the nanocrystal-orientation controlled complex having polarization singularity according to Example (with a Flake gloss in FIG. 6), the NO reduction rate was reached at 80% in about 4 minutes after start of test and the NO reduction rate was reached at 100% in about 15 minutes. As shown in FIG. 7, in the nanocrystal-orientation controlled complex having polarization singularity according to Example (with a Flake gloss in FIG. 7), the $N_2$ generation rate was reached at 60% in about 4 minutes after start of test and the $N_2$ generation rate was reached at 70% in about 15 minutes. Therefore, excellent catalytic activity with a reducing property could be obtained in Example.

Whereas, as shown in FIG. 6, in the nanocrystal complex having no polarization singularity according to Comparative Example (without a Flake gloss in FIG. 6), the NO reduction rate was reached at only less than 20% in about 4 minutes after start of test and the NO reduction rate was finally reached at 60% in about 24 minutes. In Comparative Example, it took about 55 minutes that the NO reduction rate was reach at 100%. As shown in FIG. 7, in the nanocrystal complex having no polarization singularity according to Comparative Example (without a Flake gloss in FIG. 7), the $N_2$ generation rate could not reach at 50% within a measurement time, at which the $N_2$ generation rate is evaluated as good.

[Industrial Applicability]

The nanocrystal-orientation controlled complex having polarization singularity in the thin film shape of the present invention allows a nanocrystal-orientation controlled complex to be obtained as a nanocrystal material having improved properties as the nanocrystal material (for example, excellent catalytic activity) as well as excellent handleability as an industrial component, and thus the nanocrystal-orientation controlled complex can be utilized in a wide variety of fields such as catalysts, electrode materials, artificial photosynthetic materials, and for example, can be utilized in a field of catalysts which control exhaust gas emitted from vehicles, factories, and the like.

List of Reference Signs

1     nanocrystal-orientation controlled complex
20    connected assembly
21    nanocrystal piece
22    main surface
23    end surface

**Claims**

1.  A crystal-orientation controlled complex comprising:

    a connected assembly having a thin film shape, in which a plurality of crystal pieces are connected with each other, the crystal pieces having a flake shape and having a main surface and an end surface, wherein
    the main surface has a crystal orientation relative to a specific crystal plane, and
    the thin film shaped connected assembly has a polarization singularity.

2.  The crystal-orientation controlled complex according to claim 1, wherein the crystal piece is a nanocrystal piece.

3.  The crystal-orientation controlled complex according to claim 1 or 2, wherein the crystal plane is an alternately stacked plane of atoms and a close-packed plane of atoms.

4.  The crystal-orientation controlled complex according to any one of claims 1 to 3, wherein the main surface forms a surface of the connected assembly.

5.  The crystal-orientation controlled complex according to any one of claims 1 to 4, wherein the main surface has higher catalytic activity than the end surface.

6.  The crystal-orientation controlled complex according to any one of claims 1 to 5, wherein the crystal piece is an oxide.

7.  The crystal-orientation controlled complex according to any one of claims 1 to 6, wherein the crystal piece is a copper oxide.

8.  The crystal-orientation controlled complex according to any one of claims 1 to 7, wherein an area in a plan view is 200 mm$^2$ or more and a thickness is 1 to 500 $\mu$m.

9.  A crystal orientation-controlled composite component wherein the crystal-orientation controlled complex according to any one of claims 1 to 8 is integrated with a base material.

FIG.1

FIG.2

FIG.3(a)

FIG.3(b)

FIG.4

(001) CRYSTAL PLANE

Cu

Cu

Cu

Cu

FIG.5

FIG.6

FIG.7

## INTERNATIONAL SEARCH REPORT

| | International application No. |
| --- | --- |
| | PCT/JP2019/012603 |

**A. CLASSIFICATION OF SUBJECT MATTER**
Int.Cl. B82B1/00(2006.01)i, B01D53/86(2006.01)i, B01D53/94(2006.01)i,
B01J23/72(2006.01)i, B82Y30/00(2011.01)i, C01G3/02(2006.01)i,
F01N3/10(2006.01)i
According to International Patent Classification (IPC) or to both national classification and IPC

**B. FIELDS SEARCHED**

Minimum documentation searched (classification system followed by classification symbols)
Int.Cl. B82B1/00, B01D53/86, B01D53/94, B01J23/72, B82Y30/00, C01G3/02,
F01N3/10

| Documentation searched other than minimum documentation to the extent that such documents are included in the fields searched | |
| --- | --- |
| Published examined utility model applications of Japan | 1922–1996 |
| Published unexamined utility model applications of Japan | 1971–2019 |
| Registered utility model specifications of Japan | 1996–2019 |
| Published registered utility model applications of Japan | 1994–2019 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2013-240756 A (NATIONAL INSTITUTE FOR MATERIALS SCIENCE) 05 December 2013 (Family: none) | 1-9 |
| A | WO 2017/010491 A1 (FURUKAWA ELECTRIC CO., LTD.) 19 January 2017 & US 2018/0134550 A1 & EP 3323506 A1 | 1-9 |
| A | WO 2017/010492 A1 (FURUKAWA ELECTRIC CO., LTD.) 19 January 2017 & US 2018/0133649 A1 & EP 3323507 A1 | 1-9 |
| A | JP 2018-30739 A (NIPPON ZEON CO., LTD.) 01 March 2018 (Family: none) | 1-9 |

☒ Further documents are listed in the continuation of Box C.　　☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 03 June 2019 (03.06.2019) | 11 June 2019 (11.06.2019) |

| Name and mailing address of the ISA/ | Authorized officer |
| --- | --- |
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013240756 A